# EUROPEAN PATENT APPLICATION

(11) **EP 4 773 504 A1**
(43) Date of publication of application: **08.07.2026**
(21) Application number: 25220219.7
(22) Date of filing: 02.12.2025
(51) Int. Cl.: H03B 5/12, H03B 1/04

(54) **IMPLICIT FREQUENCY MULTIPLIER**

(30) Priority: 02.01.2025 US 202519008257
(71) Applicant: NXP USA, Inc., Austin, TX 78735 (US)
(72) Inventor: Karaca, Denizhan, 5656 AG Eindhoven (NL); Copani, Tino, 5656 AG Eindhoven (NL)
(74) Representative: Schmütz, Christian Klaus Johannes

(57) **Abstract**

Systems and methods for an implicit frequency multiplier are described. In some embodiments, an implicit frequency multiplier may include a cross-coupled oscillator having a transistor pair, a primary coil coupled to source terminals of the transistor pair, and a secondary coil magnetically coupled to the primary coil. In another embodiment, a method may include operating a cross-coupled oscillator having a transistor pair and extracting a harmonic component of a current flowing through the cross-coupled oscillator using a transformer coupled to source terminals of the transistor pair.

## Description

### Field

This disclosure relates generally to electronic circuits, and more specifically, to an implicit frequency multiplier.

### Background

Oscillators are fundamental components in electronic circuits, used to generate periodic waveforms, typically in the form of sine waves or square waves. The components are essential in a wide range of applications, including communication systems, signal processing, and timing devices. As such, oscillators may be found in various forms, such as crystal oscillators, LC oscillators, and voltage-controlled oscillators (VCOs), each serving specific purposes based on their design and operational characteristics.

An important parameter in the performance of oscillators is its quality factor, or "Q factor." The Q factor is a dimensionless parameter that describes the damping of the oscillator's resonant circuit. It is defined as the ratio of the resonant frequency to the bandwidth over which the oscillator maintains oscillation. A higher Q factor indicates lower energy loss relative to the stored energy of the oscillator, resulting in a purer and more stable oscillation with less phase noise. Conversely, a lower Q factor signifies higher energy loss and greater phase noise, which can degrade the performance of the oscillator, especially at high frequencies.

Oscillators operating at high millimeter-wave frequencies, such as those above 60 GHz, often face significant challenges. These challenges include high power consumption and phase noise degradation due to the low Q factor of passive components at these frequencies. Additionally, the oscillation frequency often exhibits high sensitivity to the loading of the oscillator, making it difficult to maintain stable and accurate frequency output.

These issues complicate the design and implementation of efficient oscillators in modern electronic devices. Existing solutions typically involve designing oscillators at lower frequencies and then using additional components, such as frequency doublers, to achieve a desired high frequency.

### Brief Description of the Drawings

The present disclosure is illustrated by way of example and is not limited by the accompanying figures, in which like references indicate similar elements. Elements in the figures are illustrated for simplicity and clarity and have not necessarily been drawn to scale.
FIG. 1 is a diagram of an example of a circuit having an implicit frequency multiplier configured to extract odd harmonics from a cross-coupled oscillator, according to some embodiments.
FIG. 2 is a diagram of an example of another circuit having an implicit frequency multiplier configured to extract even harmonics from a cross-coupled oscillator, according to some embodiments.
FIG. 3 is a diagram of an example of a same polarity coupling between the secondary coil and a primary coil, according to some embodiments.
FIG. 4 is a diagram of an example of an opposite polarity coupling between the secondary coil and a primary coil, according to some embodiments.
FIGs. 5-10 are diagrams of alternative implementations of implicit frequency multipliers, according to some embodiments.

### Detailed Description

Today's oscillators are typically designed to operate at low frequencies, and their outputs are processed using additional components, such as frequency doublers, to produce high frequency signals. This approach, however, results in increased power consumption, complexity, and circuit area. Moreover, the use of an explicit frequency multiplier leads to phase noise degradation due to low Q-factor (the ratio of the resonant frequency to the bandwidth over which the oscillator maintains oscillation) at very high frequencies, and the circuit becomes subject to high sensitivity of the oscillation frequency due to the loading of the oscillator.

To address these and other concerns, systems and methods described herein provide an implicit frequency multiplier configured to extract even and odd harmonics from a cross-coupled oscillator via magnetic coupling of source currents. These systems and methods may reduce power consumption and phase noise, providing a more flexible (e.g., in terms of which order of harmonic signal to extract) and efficient approach to frequency multiplication in electronic circuits. In various implementations, an implicit frequency multiplier, as described herein, may enable a low phase-noise at high mm-wave frequencies (greater than 30 GHz) while maintaining low power consumption.

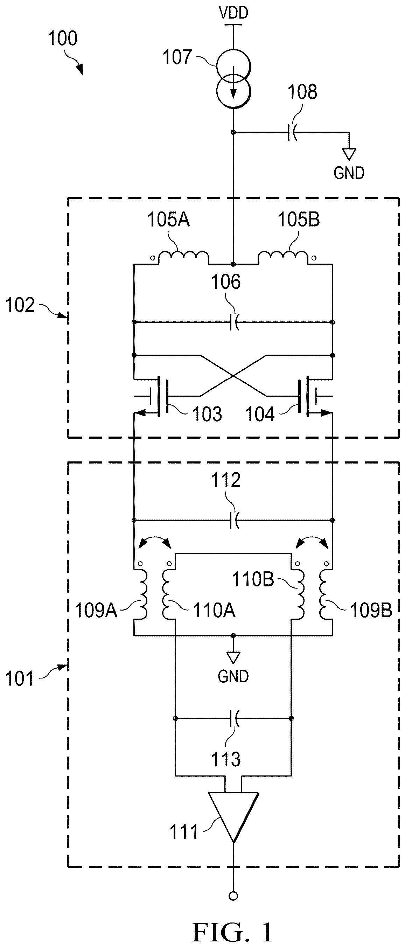

FIG. 1 shows a non-limiting example of circuit 100 with implicit frequency multiplier 101 configured to extract odd harmonics from cross-coupled oscillator 102. In various embodiments, circuit 100 may be integrated in any device, including any electronic circuitry, microprocessors, microcontrollers, memory, input output (I/O) logic control, communication interfaces, etc. Moreover, one or more components of circuit 100 may be part of a Systems-on-Chip (SoC), or the like.

In some applications, for example, circuit 100 may be used for wireless communication. For instance, implicit frequency multiplier 101 may be used in a radio system implementing various wireless communications technologies such as, for example, Wi-Fi, BLUETOOTH (BT), BT Low-Energy (BLE), Mobile Broadband, point-to-point IEEE 802.15.4, etc. Additionally, or alternatively, circuit 100 may be designed to operate with frequencies greater than 60 GHz.

As shown, cross-coupled oscillator 102 includes transistor pair 103 and 104 in a cross-coupled configuration, as shown. In this case, both transistors 103 and 104 are NMOS transistors, such that each transistor's gate terminal is coupled to the other's source terminal. An oscillator tank includes coil or inductor portions 105A and 105B (collectively referred to as "inductor 105") and capacitor 106, which together with transistors 103 and 104, form cross-coupled oscillator 102.

Cross-coupled oscillator 102 is coupled to current source 107. Particularly, the input of current source 107 is coupled to a supply voltage (vdd) and the output of current source 107 is coupled between inductor portions 105A and 105B. Radio Frequency (RF) decoupling capacitor 108 couples the output of current source 107 to a ground terminal (gnd). In some implementations, RF decoupling capacitor 108 may allow common-mode current swing in cross-coupled oscillator 102, which may be particularly important for even harmonic extraction, as discussed in more detail below.

Implicit frequency multiplier 101 operates, in part, by extracting harmonic contents of oscillator 102 via magnetic-coupling of source currents and providing a frequency-multiplier output via buffer 111. Primary coil or inductor portions 109A and 109B (collectively referred to as "primary inductor 109") are electrically coupled to the source terminals of transistors 103 and 104, respectively, and to a ground terminal. Primary inductor portions 109A and 109B are also magnetically coupled to secondary coil or inductor portions 110A and 110B (collectively referred to as "secondary inductor 110").

Secondary inductor 110 provides an inducted signal to buffer 111, the inducted signal corresponding to a selected harmonic of the natural output of cross-coupled oscillator 102, the selected harmonic being an implicitly frequency multiplied version of that natural output. Buffer 111 in turn provides a frequency multiplied signal as the output of circuit 100.

In various embodiments, due to the differential nature of the cross-coupled oscillator, an implicit frequency multiplier may be used to extract odd harmonic current components that are of equal magnitude and with 180 degrees out of phase with the natural output of the oscillator. Alternatively, an implicit frequency multiplier may be used to extract even harmonic current components that are of equal magnitude and in-phase.

In the embodiment of FIG. 1, primary inductor portion 109B is magnetically coupled to secondary inductor portion 110B with the same polarity. In other words, the polarity of the coupling between inductor portions 109B and 110B is the same as that of the coupling between inductor portions 109A and 110A, which means implicit frequency multiplier 101 is configured to extract odd harmonic content (e.g., x3, x5, etc.) from cross-coupled oscillator 102.

In this case, even harmonic signal components are destructively added on secondary inductor 110, while odd harmonic signal components are added constructively. As a result, the output signal spectrum includes only odd harmonic signal components and is free of even harmonic signal components. In various implementations, this configuration may be achieved by using a transformer, such that the center tap of primary inductor 109 is grounded.

Circuit 100 also includes tuning capacitors 112 and 113 coupled between primary inductor portions 109A and 109B, and secondary inductor portions 110A and 110B, respectively. In various embodiments, tuning capacitors 112 and 113 may be chosen to add frequency selectivity by tuning the resonance of implicit frequency multiplier 101 to a desired harmonic frequency. Generally, the greater the harmonic, the smaller the amplitude of the frequency multiplied signal.

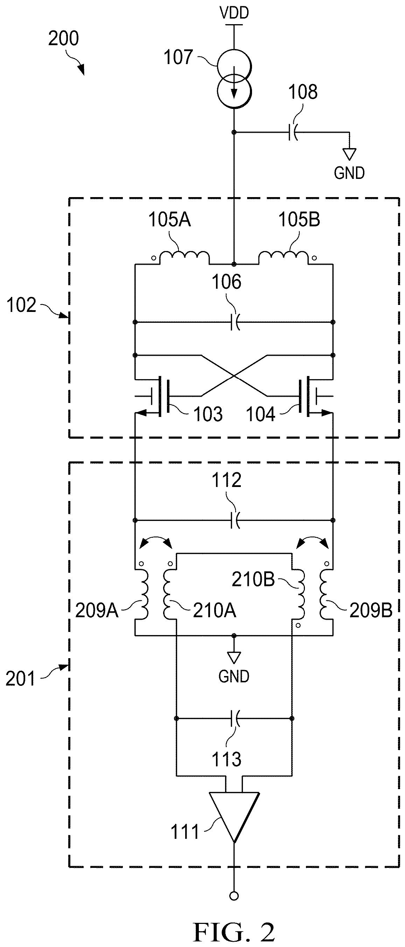

In contrast, FIG. 2 shows another circuit 200 with implicit frequency multiplier 201 having primary inductor 209 and secondary inductor 210 configured to extract even harmonics from cross-coupled oscillator 102, according to some embodiments. Unlike circuit 100, circuit 200 shows primary inductor portion 209B magnetically coupled to secondary inductor portion 210B with opposite polarity. That is, the polarity of the coupling between inductor portions 209B and 210B is opposite to that of the coupling between inductor portions 209A and 210A. Accordingly, implicit frequency multiplier 201 is configured to extract even harmonic content (*e.g.,* x2, x4, x6, etc.) from cross-coupled oscillator 102.

In this case, odd harmonic components are destructively added on the secondary inductor 210, while even harmonic signal components are added constructively. As a result, the output signal spectrum includes only even harmonic signal components and is free of odd harmonic signal components. In various implementations, this configuration may be achieved by using a transformer, where primary inductor 209 includes a coil with its center tap grounded, and secondary inductor 210 includes an 8-shaped coil.

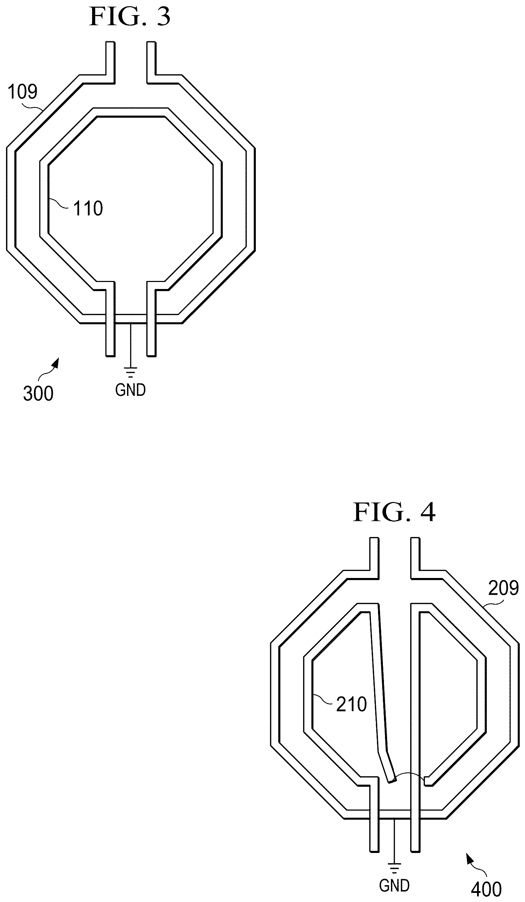

FIG. 3 is a diagram of an example of same polarity coupling 300 between a secondary coil and a primary coil. In various embodiments, same polarity coupling 300 may be used to extract odd harmonics, as described in connection with FIG. 1. In this implementation, primary inductor 109 has an octagonal shape, with a center tap coupled to ground. Secondary inductor 110 has the same general shape as primary inductor 109 and forms a transformer therewith, such that a first electrical signal flowing through primary inductor 109 magnetically induct a second electrical signal though secondary inductor 110, the second signal being an odd harmonic of the first signal.

FIG. 4 is a diagram of an example of opposite polarity coupling 400 between a secondary coil and a primary coil. In various embodiments, opposite polarity coupling 400 may be used to extract even harmonics, as described in connection with FIG. 2. In this implementation, primary inductor 209 still has an octagonal shape, with a center tap coupled to ground. Secondary inductor 210 also has the same general shape as primary inductor 109, but half of secondary inductor 210-e.g., 210B-is crossed so that, in that portion, electrical current flows in an opposite direction as in primary inductor 109.

Primary and second inductors 209 and 210 also form a transformer, such that a first electrical signal flowing through primary inductor 209 magnetically inducts a second electrical signal though secondary inductor 210, the second signal being an even harmonic of the first signal.

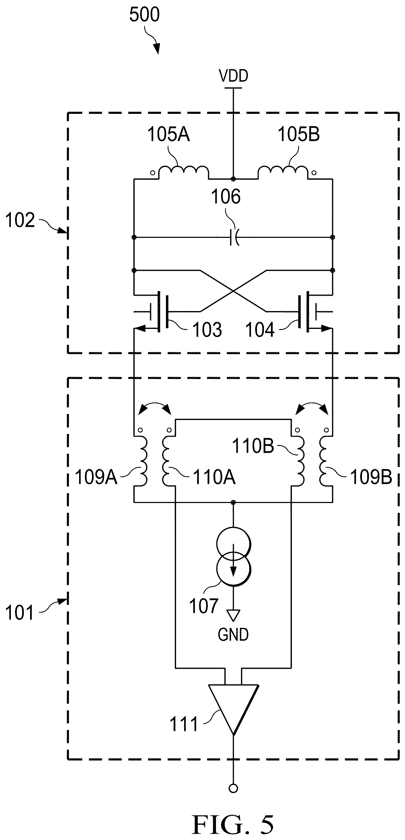

FIGs. 5-10 are diagrams of alternative implementations of implicit frequency multipliers 501-1001 coupled to a cross-coupled oscillator 102 and providing different configurations of circuits 500-1000, respectively. In circuits 500-1000, RF decoupling capacitors and tuning capacitors are omitted for ease of visualization.

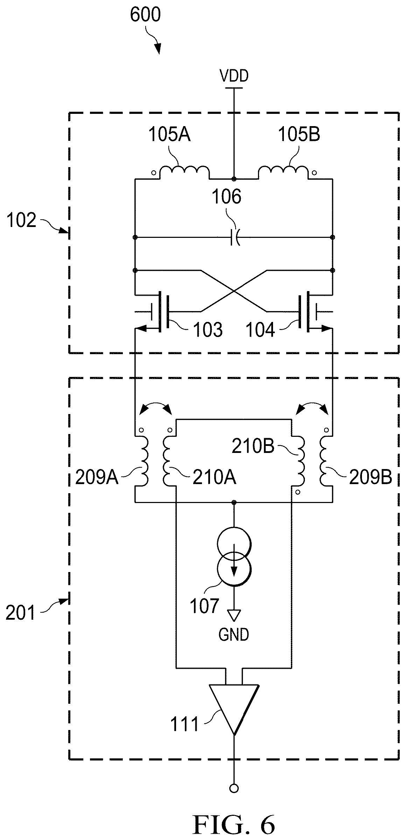

Specifically, circuit 500 of FIG. 5 shows a configuration where the transistor pair of cross-coupled oscillator 102 includes tail-biased, NFET transistors, and implicit frequency multiplier 501 is configured for odd harmonic extraction (same polarity between primary induction portion 109B and secondary induction portion 110B). In this case, cross-coupled oscillator 102 is coupled to the voltage supply, and current source 107 is coupled between the center tap of primary inductor 109 and the ground terminal (gnd). In FIG. 6, circuit 600 is similar to circuit 500; but it shows implicit frequency multiplier 601 configured for even harmonic extraction (opposite polarity between primary induction portion 209B and secondary induction portion 210B).

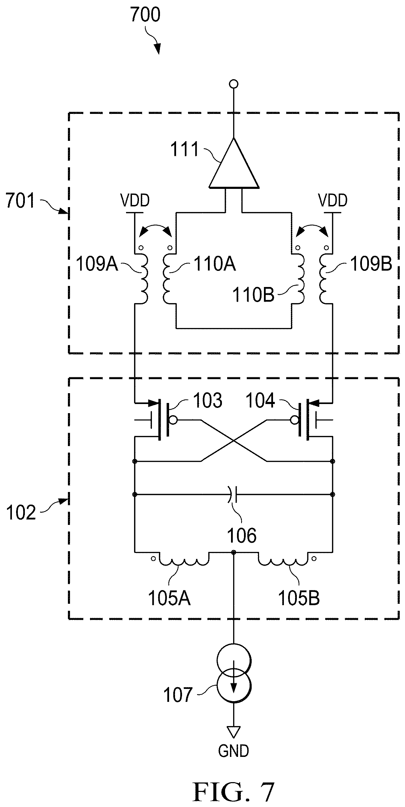

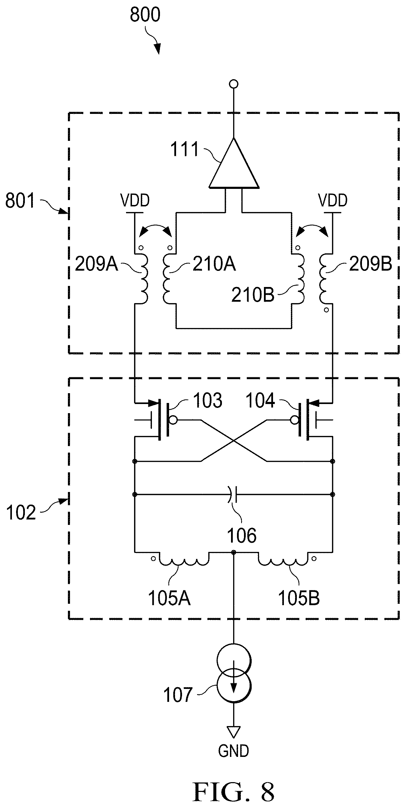

Circuit 700 of FIG. 7 shows a configuration where the transistor pair of cross-coupled oscillator 102 includes tail-biased, PFET transistors, and implicit frequency multiplier 701 is configured for odd harmonic extraction (same polarity between primary induction portion 109B and secondary induction portion 110B). In this case, cross-coupled oscillator 102 is coupled to current source 107, and the center tap of primary inductor 109 is coupled to the voltage supply (vdd). In FIG. 8, circuit 800 is similar to circuit 700; but it shows implicit frequency multiplier 801 configured for even harmonic extraction (opposite polarity between primary induction portion 209B and secondary induction portion 210B).

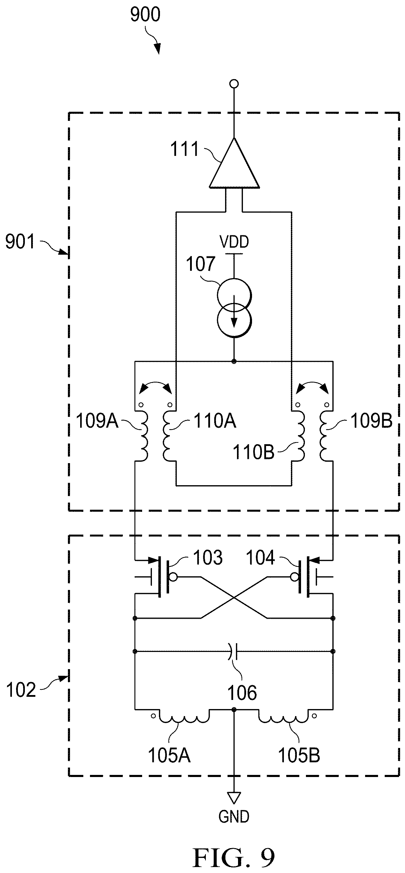

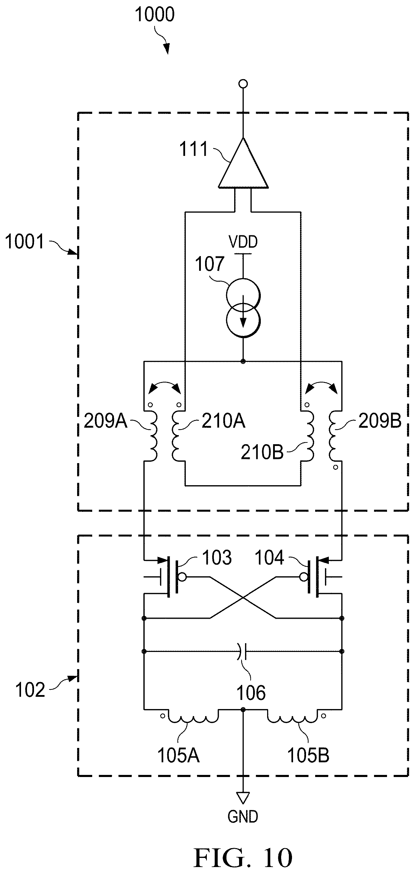

Circuit 900 of FIG. 9 shows a configuration where the transistor pair of cross-coupled oscillator 102 includes top-biased, PFET transistors, and implicit frequency multiplier 901 is configured for odd harmonic extraction (same polarity between primary induction portion 109B and secondary induction portion 110B). In this case, cross-coupled oscillator 102 is coupled to current source 107, and the center tap of primary inductor 109 is coupled to ground (gnd), and current source 107 is coupled to the center tap of primary inductor 109. In FIG. 10, circuit 1000 is similar to circuit 900; but it shows implicit frequency multiplier 1001 configured for even harmonic extraction (opposite polarity between primary induction portion 209B and secondary induction portion 210B).

As such, the systems and methods described herein introduce implicit frequency multipliers that significantly enhance the performance and efficiency of high-frequency oscillators. For example, implicit frequency multiplication in cross-coupled oscillators may be achieved through the magnetic coupling of source currents. This allows for the extraction of even and odd harmonic content without the need for explicit frequency multipliers, thereby reducing power consumption and phase noise. Additionally, these systems and methods introduce a transformer network with specific coupling configurations, including the use of an 8-shaped coil for even harmonic extraction, which provides solution for harmonic extraction in high-frequency oscillators. The addition of capacitors to tune the transformer resonance to the desired harmonic frequency further enhances frequency selectivity, allowing for precise harmonic extraction. Alternative configurations, including NFET and PFET top-biased and tail-biased designs, offer flexibility in design and implementation, adaptable to a wide range of applications.

One or more embodiments of the present disclosure may include features recited in the following numbered clauses:
1. An implicit frequency multiplier, comprising: a cross-coupled oscillator having a transistor pair; a primary coil coupled to source terminals of the transistor pair; and a secondary coil magnetically coupled to the primary coil.
2. The implicit frequency multiplier of clause 1, wherein a first portion of the primary coil has a given polarity, and wherein a first portion of the secondary coil has the given polarity.
3. The implicit frequency multiplier of clause 2, wherein a second portion of the primary coil has the given polarity, and wherein a second portion of the secondary coil has the given polarity.
4. The implicit frequency multiplier of clause 3, wherein the secondary coil is configured to extract an odd current harmonic component from the cross-coupled oscillator.
5. The implicit frequency multiplier of clause 3, wherein a center tap of the primary coil is grounded.
6. The implicit frequency multiplier of clause 2, wherein a second portion of the primary coil has the given polarity, and a second portion of the secondary coil has another polarity opposite the given polarity.
7. The implicit frequency multiplier of clause 6, wherein the secondary coil is configured to extract an even current harmonic component from the cross-coupled oscillator.
8. The implicit frequency multiplier of clause 6, wherein the secondary coil comprises an 8-shaped coil.
9. The implicit frequency multiplier of clause 1, further comprising: a tank circuit coupled to the transistor pair; a current source coupled to the tank circuit; and a decoupling capacitor coupled in parallel with the current source.
10. The implicit frequency multiplier of clause 1, further comprising a buffer coupled to the secondary coil.
11. The implicit frequency multiplier of clause 1, further a tuning capacitor coupled between the source terminals of the transistor pair.
12. The implicit frequency multiplier of clause 1, further a tuning capacitor coupled between across the secondary coil.
13. A circuit, comprising: a first portion of a primary coil coupled to a source terminal of a first transistor; a second portion of the primary coil coupled to a source terminal of a second transistor cross-coupled to the first transistor; a first portion of a secondary coil magnetically coupled to the first portion of the primary coil; and a second portion of the secondary coil magnetically coupled to the second portion of the primary coil.
14. The circuit of clause 13, wherein the first portions of the primary and secondary coils have the same polarity.
15. The circuit of clause 14, wherein the second portions of the primary and secondary coils have the same polarity, and wherein the secondary coil is configured to extract an odd current harmonic component from the primary coil.
16. The circuit of clause 14, wherein the second portion of the primary coil has the same polarity, wherein the second portion of the secondary coil has the opposite polarity, and wherein the secondary coil is configured to extract an even current harmonic component from the primary coil.
17. The circuit of clause 13, wherein the secondary coil comprises an 8-shaped coil.
18. A method, comprising: operating a cross-coupled oscillator having a transistor pair; and extracting a harmonic component of a current flowing through the cross-coupled oscillator using a transformer coupled to source terminals of the transistor pair.
19. The method of clause 18, further comprising: using a first polarity configuration to extract an odd harmonic component, or using a second polarity configuration to extract an even harmonic component.
20. The method of clause 18, wherein the transformer comprises a primary coil coupled to the source terminals of the transistor pair and a secondary coil magnetically coupled to the primary coil, the method further comprising tuning a resonance frequency of the transformer, at least in part, via a tuning capacitor coupled to the secondary coil.

In many implementations, systems and methods described herein may be incorporated into a wide range of electronic devices including, for example, computer systems or Information Technology (IT) products; consumer devices or appliances; scientific instrumentation; industrial robotics; medical or laboratory electronics; transportation vehicles such as automobiles, buses, trucks, trains, watercraft, aircraft, etc.; military equipment, etc.

For sake of brevity, conventional techniques have not been described in detail herein. Furthermore, the connecting lines shown in the various figures contained herein have been intended to illustrate relationships (e.g., logical) or physical couplings (e.g., electrical) between the various elements. It should be noted, however, that alternative relationships and connections may be used in other embodiments. Moreover, circuitry described herein may be implemented either in silicon or another semiconductor material or alternatively by software code representation thereof.

Although various systems and methods are described herein with reference to specific embodiments, modifications and changes may be made without departing from the scope of the present disclosure, as set forth in the claims below. Accordingly, the specification and figures are to be regarded in an illustrative rather than a restrictive sense, and all such modifications are intended to be included. Any benefits, advantages, or solutions to problems that are described herein regarding specific embodiments are not intended to be construed as a critical, required, or essential feature or element of any or all the claims.

Reference is made herein to "configuring" a device or a device "configured to" perform some operation(s). This may include selecting predefined logic blocks and logically associating them. It may also include programming computer software-based logic of a retrofit control device, wiring discrete hardware components, or a combination thereof. Such configured devices are physically designed to perform the specified operation(s).

Unless stated otherwise, terms such as "first" and "second" are used to arbitrarily distinguish between the elements such terms describe. Thus, these terms are not necessarily intended to indicate temporal or other prioritization of such elements. The terms "coupled" or "operably coupled" are defined as connected, although not necessarily directly, and not necessarily mechanically. The terms "a" and "an" are defined as one or more unless stated otherwise. The terms "comprise" (and any form of comprise, such as "comprises" and "comprising"), "have" (and any form of have, such as "has" and "having"), "include" (and any form of include, such as "includes" and "including") and "contain" (and any form of contain, such as "contains" and "containing") are open-ended linking verbs. As a result, a system, device, or apparatus that "comprises," "has," "includes" or "contains" one or more elements possesses those one or more elements but is not limited to possessing only those one or more elements. Similarly, a method or process that "comprises," "has," "includes" or "contains" one or more operations possesses those one or more operations but is not limited to possessing only those one or more operations.

## Claims

1. An implicit frequency multiplier, comprising:
a cross-coupled oscillator having a transistor pair;
a primary coil coupled to source terminals of the transistor pair; and
a secondary coil magnetically coupled to the primary coil.

2. The implicit frequency multiplier of claim 1, wherein a first portion of the primary coil has a given polarity, and wherein a first portion of the secondary coil has the given polarity.

3. The implicit frequency multiplier of claim 1 or 2, wherein a second portion of the primary coil has the given polarity, and wherein a second portion of the secondary coil has the given polarity.

4. The implicit frequency multiplier of any of the preceding claims, wherein the secondary coil is configured to extract an odd current harmonic component from the cross-coupled oscillator.

5. The implicit frequency multiplier of any of the preceding claims, wherein a center tap of the primary coil is grounded.

6. The implicit frequency multiplier of claim 2, wherein a second portion of the primary coil has the given polarity, and a second portion of the secondary coil has another polarity opposite the given polarity.

7. The implicit frequency multiplier of claim 6, wherein the secondary coil is configured to extract an even current harmonic component from the cross-coupled oscillator.

8. The implicit frequency multiplier of claim 6 or 7, wherein the secondary coil comprises an 8-shaped coil.

9. The implicit frequency multiplier of any of the preceding claims, further comprising: a tank circuit coupled to the transistor pair; a current source coupled to the tank circuit; and a decoupling capacitor coupled in parallel with the current source.

10. The implicit frequency multiplier of any of the preceding claims, further comprising a buffer coupled to the secondary coil.

11. The implicit frequency multiplier of any of the preceding claims, further a tuning capacitor coupled between the source terminals of the transistor pair.

12. The implicit frequency multiplier of any of the preceding claims, further a tuning capacitor coupled between across the secondary coil.

13. A circuit, comprising:
a first portion of a primary coil coupled to a source terminal of a first transistor;
a second portion of the primary coil coupled to a source terminal of a second transistor cross-coupled to the first transistor;
a first portion of a secondary coil magnetically coupled to the first portion of the primary coil; and
a second portion of the secondary coil magnetically coupled to the second portion of the primary coil.

14. A method, comprising:
operating a cross-coupled oscillator having a transistor pair; and
extracting a harmonic component of a current flowing through the cross-coupled oscillator using a transformer coupled to source terminals of the transistor pair.

15. The method of claim 15, further comprising: using a first polarity configuration to extract an odd harmonic component, or using a second polarity configuration to extract an even harmonic component.
